Europäisches Patentamt

European Patent Office

Office européen des brevets

(19)

(11) **EP 1 252 714 B1**

(12) **EUROPÄISCHE PATENTSCHRIFT**

(45) Veröffentlichungstag und Bekanntmachung des Hinweises auf die Patenterteilung:
**12.11.2003 Patentblatt 2003/46**

(21) Anmeldenummer: **01900039.7**

(22) Anmeldetag: **15.01.2001**

(51) Int Cl.⁷: **H03M 1/06**, G01F 15/04

(86) Internationale Anmeldenummer:
**PCT/IB01/00030**

(87) Internationale Veröffentlichungsnummer:
**WO 01/058019 (09.08.2001 Gazette 2001/32)**

(54) **A/D-WANDLER MIT LOOKUP-TABELLE**

A/D CONVERTER WITH LOOKUP TABLE

CONVERTISSEUR ANALOGIQUE/NUMERIQUE AVEC TABLE DE RECHERCHE

(84) Benannte Vertragsstaaten:
**DE FR GB**

(30) Priorität: **04.02.2000 CH 22000**

(43) Veröffentlichungstag der Anmeldung:
**30.10.2002 Patentblatt 2002/44**

(73) Patentinhaber: **Sensirion AG**
**8052 Zürich (CH)**

(72) Erfinder:
- **HAEBERLI, Andreas, Martin**
  **CH-8616 Riedikon (CH)**
- **ROTHACHER, Urs, Martin**
  **CH-8006 Zürich (CH)**
- **MAYER-FRIEDRICH, Felix, Martin**
  **CH-8057 Zürich (CH)**

(74) Vertreter: **Blum, Rudolf Emil Ernst**
**c/o E. Blum & Co**
**Patentanwälte**
**Vorderberg 11**
**8044 Zürich (CH)**

(56) Entgegenhaltungen:
**EP-A- 0 309 644      EP-A- 0 514 587**
**EP-A- 0 889 386      US-A- 4 707 798**
**US-A- 4 986 243**

- **PATENT ABSTRACTS OF JAPAN vol. 1999, no. 12, 29. Oktober 1999 (1999-10-29) & JP 11 190653 A (TOKYO GAS CO LTD), 13. Juli 1999 (1999-07-13)**

**Beschreibung**

Hinweis auf verwandte Anmeldungen

Diese Anmeldung beansprucht die Priorität der Schweizer Patentanmeldung 0220/00, die am 4. Februar 2000 eingereicht wurde und deren ganze Offenbarung hiermit durch Bezug aufgenommen wird.

Hintergrund

Die Erfindung betrifft einen A/D-Wandler gemäss Oberbegriff der unabhängigen Ansprüche.

Bei der Aufbereitung bzw. Verarbeitung von Messwerten ist es oftmals nötig, mehrere Eingangssignale miteinander zu verknüpfen um ein gewünschtes Ausgangssignal zu erhalten. Beispielsweise sind Druck- oder Flusssensoren in der Regel temperaturabhängig, so dass deren Signal noch aufgrund der momentanen Temperatur korrigiert werden muss. Dies geschieht in der Regel in digitalen Recheneinheiten.

Normalerweise werden hierzu alle Messsignale zuerst digitalisiert und sodann rechnerisch oder mittels einer Tabelle miteinander verknüpft. Bei einer rechnerischen Verknüpfung müssen jedoch Multiplikationen oder Divisionen ausgeführt werden, was nur in komplizierten Schaltungen möglich ist. Ebenso werden allfällige Tabellen bei hoher Auflösung sehr gross. Um die Tabellengrösse zu reduzieren, kann zwar auf eine Interpolation zwischen den Tabellenwerten zurückgegriffen werden, was jedoch wiederum Multiplikationen oder Divisionen bedingt.

Darstellung der Erfindung

Es stellt sich deshalb die Aufgabe, einen A/D-Wandler der eingangs genannten Art bereitzustellen, welcher in der Lage ist, zwei oder mehrere analoge Eingangswerte zu verknüpfen und ein Ausgangssignal hoher Präzision zu erzeugen, wobei die benötigte Schaltung möglichst klein bleiben soll.

Diese Aufgabe wird vom A/D-Wandler gemäss Anspruch 1 gelöst.

Erfindungsgemäss wird also jedem Eingang ein Wandler zugeordnet, der einen Digitalwert erzeugt. Die Digitalwerte aller Wandler werden zusammen einer Tabelle zugeführt und in einen Lookup-Wert umgewandelt. Mehrere aufeinander folgende Lookup-Werte werden sodann in einem Dezimationsfilter gefiltert, z.B. addiert oder gemittelt, um einen Ausgangswert zu erzeugen, der eine höhere Auflösung als der Lookup-Wert besitzt. Diese Architektur erlaubt es, Wandler mit relativ geringer Auflösung zu verwenden, was die Grösse der Tabelle reduziert und es erlaubt, die ganze Schaltung klein zu halten, da auch die Verknüpfung der zwei oder mehr Eingangssignale bei tiefer Auflösung erfolgt. Erst durch die Addition bzw. Mittelung oder Filterung nach der Tabelle wird sodann die gewünschte hohe Auflösung erreicht.

Die Tabelle ist vorzugsweise als Speicher organisiert, sie kann aber auch als Rechenwerk implementiert werden.

Da die Tabelle in der Regel eine Nichtlinearität zwischen Ein- und Ausgangssignal erzeugt, wird eine Offsetkompensation der Schaltung vorzugsweise dadurch erreicht, dass die Digitalwerte zwischen den Wandlern und der Tabelle mit einem Korrekturwert korrigiert werden.

In einem weiteren Aspekt der Erfindung stellt sich die Aufgabe, einen A/D-Wandler der eingangs genannten Art mit einem oder zwei Eingängen bereitzustellen, der eine möglichst effiziente Offsetkorrektur erlaubt. Diese Aufgabe wird auch vom Gegenstand der unabhängigen Ansprüche erfüllt.

Auch hierzu werden die Digitalwerte zwischen dem Wandler und der Tabelle mit einem Korrekturwert korrigiert. Der Korrekturwert kann ermittelt werden, indem ein bekannter analoger Eingangswert (vorzugsweise 0 Volt) an den jeweiligen Wandler, und gegebenenfalls eine vor dem Wandler liegende, als Teil des Wandlers betrachtete Analogstufe, angelegt und der Offset des entsprechenden Digitalwerts von seinem Sollwert verglichen wird. Um die Auflösung der Korrektur zu erhöhen, werden die Offsets von n Digitalwerten addiert um ein Korrekturwort k zu erzeugen. Der auf die nächst tiefere Ganzzahl gerundete Wert von k/n, d.h. der Wert k div n, wird sodann zur Offsetkompensation jedes Digitalwerts verwendet. Um die Auflösung weiter zu erhöhen, kann insgesamt der Wert k mod n, d.h. der Divisionsrest, zur Korrektur einer Gruppe von n zu kompensierenden Digitalwerten addiert bzw. subtrahiert werden, indem ein Teil der Digitalwerte der Gruppe korrigiert wird. Vorzugsweise werden k mod n Digitalwerte der Gruppe um einen Wert von 1 korrigiert. Um diese Rechenoperationen zu erleichtern, ist n vorzugsweise eine ganzzahlige Potenz von 2.

Die folgenden Ausführungen gelten für beide Aspekte der Erfindung.

Als Wandler werden vorzugsweise Schaltungen eingesetzt, die einen Umsetzer aufweisen, der den Eingangswert in eine Folge von Binärwerten umwandelt, wobei die Zahl der Binärwerte mit Wert 1 proportional zum Eingangswert ist. Durch Zählen der Binärwerte während einer Messperiode kann der gewünschte Digitalwert erzeugt werden. Beispiele für solche Wandler sind inkrementale Wandler oder $\Sigma\Delta$-Wandler.

Bei Verwendung derartiger Wandler kann die Tabelle Differenzwerte erzeugen, die bei jeder Erhöhung eines Zählers abgerufen und zum Wert einer als Dezimationsfilter verwendeten Integrationsstufe hinzuaddiert werden. Vorzugsweise wird gleichzeitig eine Proportionalitätskonstante addiert, so dass in der Tabelle nur die Abweichungen zu einer entsprechenden linearen Interpolation abgespeichert sein müssen, was den Speicherbedarf weiter reduzieren kann.

Um die Zahl der Tabellenzugriffe zu reduzieren, kann die Tabelle über eine Cache-Schaltung angesteuert werden, welche einen Teil der erzeugten Adresswerte und die dazugehörigen Lookup-Werte zwischenspeichert und gegebenenfalls ohne Benutzung der Tabelle ausgibt. Dies kann die Leistungsaufnahme und/oder von der Schaltung erzeugte elektrische Störsignale reduzieren.

Kurze Beschreibung der Zeichnungen

Weitere Ausgestaltungen, Vorteile und Anwendungen der Erfindung ergeben sich aus den abhängigen Ansprüchen und aus der nun folgenden Beschreibung anhand der Figuren. Dabei zeigen:

> Fig. 1 ein vereinfachtes Blockdiagramm eines erfindungsgemässen A/D-Wandlers,
> Fig. 2 eine erste konkrete Ausführung der Erfindung mit Offsetkorrektur,
> Fig. 3 eine zweite konkrete Ausführung der Erfindung mit reduzierter Tabellengrösse und
> Fig. 4 eine Blockdiagramm einer Ausführung mit Cache-Speicherzugriff.

Wege zur Ausführung der Erfindung

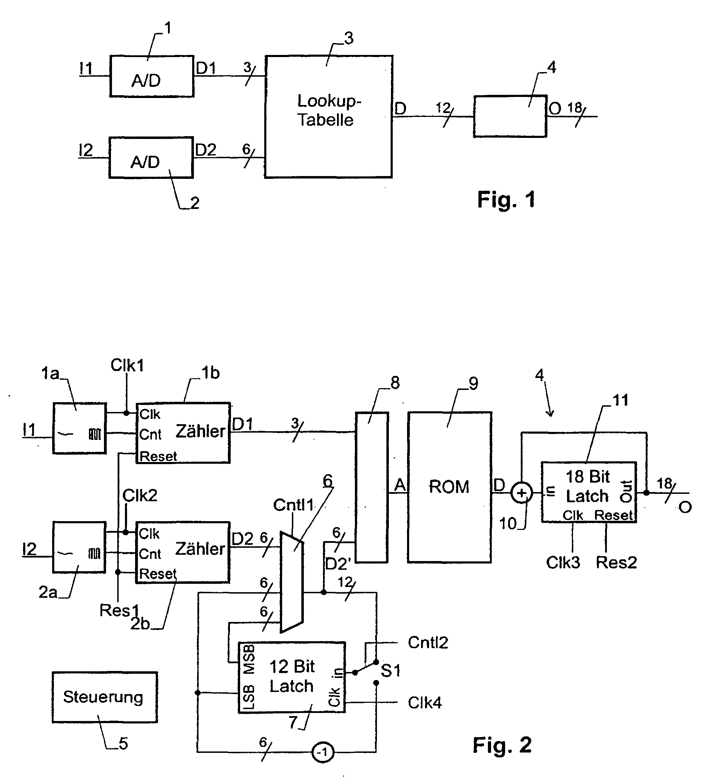

Die Schaltung nach Fig. 1 zeigt einen A/D-Wandler mit zwei analogen Eingängen I1, I2 und einem Digitalausgang, wobei der Ausgangswert O eine Funktion beider Eingangswerte ist. Eine derartige Schaltung kann z.B. in einem Gasflusssensor eingesetzt werden, welcher das Signal des eigentlichen Flusssensors an den Eingang I2 und zusätzlich das Signal eines Temperatursensors an den Eingang I1 führt. Die Aufgabe des A/D-Wandlers liegt in diesem Fall darin, den effektiven Gasfluss als Ausgangswert O zu erzeugen, wobei einerseits eine Nichtlinearität des Flusssensors, andererseits dessen Temperaturabhängigkeit korrigiert werden soll.

Zu diesem Zweck ist bei den Eingängen I1, I2 je ein Wandler 1 bzw. 2 angeordnet. Dabei handelt es sich um Analog-Digital-Wandler mit geringer Auflösung. Im vorliegenden Fall besitzen sie eine Auflösung von 3 bzw. 6 Bit. Die Wandler sind so beschaffen, dass die von ihnen erzeugten Digitalwerte D1 bzw. D2 zwar geringe Auflösung haben, dass aber die Mittelwerte von D1 bzw. D2 über mehrere Messungen hinweg sich auf einen Wert höherer Auflösung einpendeln. Wandler dieser Art werden bei "over-sampling"-Techniken eingesetzt und sind z.B. sogenannte inkrementale A/D-Wandler oder $\Sigma\Delta$-Wandler.

Die Digitalwerte D1 und D2 der Wandler 1, 2 werden Lookup-Tabelle 3 zugeführt. Diese kann als zweidimensionale Matrix von Daten aufgefasst werden, die für jedes Wertepaar von D1 und D2 einen Lookup-Wert D enthält. Sie kann, wie unten beschrieben, als Speicherbaustein implementiert werden, oder als Rechenwerk. Da die Werte D1 und D2 lediglich 3 bzw. 6 Bit lang sind, ist der Umfang der Tabelle verhältnismässig klein.

Der Lookup-Wert D besitzt im vorliegenden Ausführungsbeispiel eine Auflösung von 12 Bit. Er wird einer als Dezimationsfilter verwendeten Integrationsstufe 4 zugeführt. Dieses filtert mehrere Lookup-Werte D, z.B. durch Addition bzw. Mittelung, um die Auflösung der Messung zu erhöhen, und erzeugt einen Ausgangswert O einer Breite von z.B. 18 Bit. Dieser Ausgangswert kann bei Bedarf noch skaliert werden, indem z.B. die tiefstwertigen Bits abgeschnitten werden.

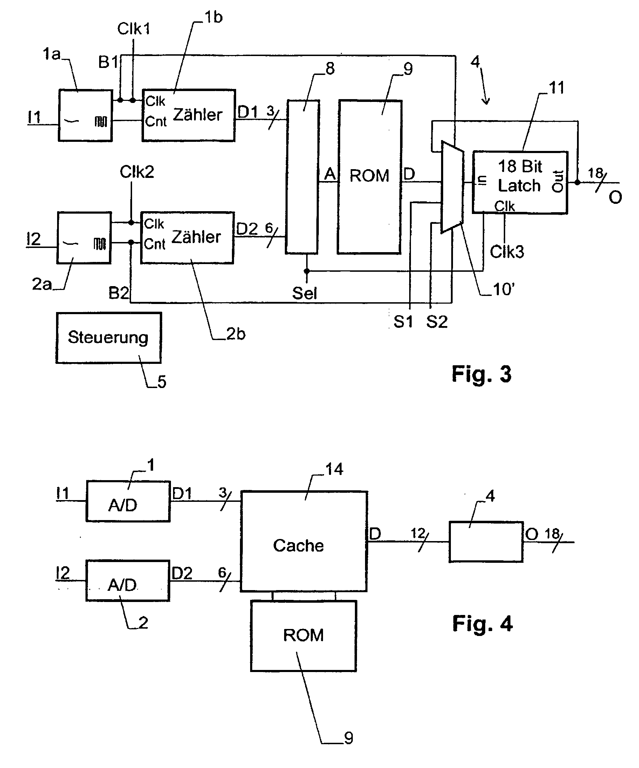

Fig. 2 zeigt eine konkrete Ausführung einer erfindungsgemässen Schaltung, welche zusätzlich mit einer Offsetkorrektur ausgerüstet ist.

Hier bestehen die Wandler 1, 2 je aus einem Inkrementalwandler, dem gegebenenfalls noch eine analoge Verbarbeitungsstufe vorgeschaltet sein kann. Jeder Inkrementalwandler umfasst einen Umsetzer 1a bzw. 2a und einen Zähler 1b bzw. 2b. Der Umsetzer 1a, 2a erzeugt mit jedem Taktsignal Clk1 bzw. Clk2 aus dem Eingangswert einen Binärwert B1 bzw. B2, wobei, über die Zeit gemittelt, die Zahl der Binärwerte B1 bzw. B2 mit Wert 1 proportional zum Eingangswert ist. Der Zähler zählt die innerhalb einer Messperiode anfallenden Binärwerte des Wertes 1 und erzeugt den Digitalwert D1 bzw. D2. Am Schluss jeder Messperiode werden die Zähler 2a, 2b über Signal Res1 zurückgesetzt.

Im vorliegenden Fall ist der Digitalwert D1 von geringerer Auflösung (z.B. 3 Bits) als der Digitalwert D2 (6 Bits), da letzterer eine stärkere Korrektur erfordert. Der zweite Wandler 2a, 2b wird deshalb mit einer z.B. acht mal höheren Taktrate angetrieben als der erste Wandler 1a, 1b, so dass die Messperioden beider Wandler gleich lang sind, oder es werden beide Wandler mit der gleichen Taktrate angetrieben und mit Zählern gleicher Länge ausgerüstet, vom Zähler 1b werden aber nur die höchstwertigen Bits weiterverarbeitet, oder der Zähler stoppt nach der gewünschten Anzahl Bits. Zur Erzeugung aller Takt- und Steuersignale ist eine Steuerung 5 vorgesehen.

In der Ausführung nach Fig. 2 wird der Messwert D2 einer Offsetkompensation zugeführt, welche im wesentlichen aus einer Arithmetikeinheit 6 und einem Register bzw. Wertespeicher 7 besteht.

Die Offsetkompensation besitzt einen Korrektur- und einen Normalmodus, die von Steuereingängen Cntl1 und Cntl2 kontrolliert werden. Im Korrekturmodus wird der Offset der Digitalwerte D2 ermittelt, im Normalmodus werden normale Messungen durchgeführt und der Offset in den Digitalwerten D2 wird kompensiert, um kompensierte Digitalwerte D2' zu erzeugen. Diese Modi werden im folgenden beschrieben:

Im Korrekturmodus wird der Analogeingang I2 auf 0 (oder einen anderen, vorgegebenen Wert) gesetzt. Falls die Vorrichtung vor dem Analogeingang I2 noch eine analoge Stufe, wie z.B. einen Verstärker besitzt, so kann auch der Eingang der analogen Stufe auf 0 gesetzt werden, um auch deren Offset zu berücksichtigen. Die so ermittelten Digitalwerte D2 werden der Arithmetikeinheit 6 zugeführt. In diesem Betriebsmodus addiert die Arithmetikeinheit den 6 Bit Digitalwert D2 zu einem 12 Bit Digitalwert bestehend aus sechs tiefen Bits LSB und sechs hohen Bits MSB, die vom Register 7 kommen. Die Summe wird als 12 Bit Wert über einen Schalter S1 dem Eingang von Register 7 zugeführt. Am Schluss jeder Messperiode des Wandlers 2a, 2b wird ein Taktsignal Clk4 erzeugt und der so erzeugte Wert wird im Register 7 abgespeichert und erscheint als 12 Bit Korrekturwort k an den Ausgängen MSB, LSB, um zum nächsten Digitalwert D2 hinzuaddiert zu werden. Somit werden die Digitalwerte D2 (die ohne Offset 0 sein müssten) im Zähler aufaddiert.

Der Korrekturmodus erstreckt sich über n = $2^6$ Messperioden des Wandlers 2a, 2b, um ein Korrekturwort k hoher Auflösung zu erhalten. Danach wird die Schaltung in den Normalmodus zurückgestellt.

Im Normalmodus subtrahiert die Arithmetikeinheit 6 einen Korrekturwert der Grösse k div n vom Digitalwert D2. Da n eine ganzzahlige Potenz von 2 ist, entspricht der Wert k div n den höchstwertigen Bits des Korrekturworts k, im vorliegenden Fall den als MSB bezeichneten sechs höchstwertigen Bits. Zudem subtrahiert die Arithmetikeinheit 6 noch zusätzlich den Wert 1 vom Digitalwert D2, falls die mit LSB bezeichneten sechs tiefstwertigen Bits vom Register 7 grösser als 0 sind.

Der auf diese Weise kompensierte Digitalwert wird sodann der Tabelle zugeführt.

Zu Beginn des Messmodus ist der Wert LSB gleich k mod n. Am Ende jeder Messperiode werden die tiefwertigen Bits LSB aus Register 7 um 1 dekrementiert und über den nun umgeschalteten Schalter S1 wieder ins Register 7 eingespeichert, so dass der Wert LSB nach jeder Messperiode um 1 kleiner wird. Damit ist der Wert LSB nach n Messperioden wieder gleich k mod n. Es kann also ein neuer Messzyklus beginnen, oder es kann ein neuer Durchgang im Korrekturmodus erfolgen.

Somit werden von n Digitalwerten D2 jeweils die ersten k mod n Digitalwerte zusätzlich um 1 nach unten korrigiert. Dies ergibt eine Feinkorrektur, da die Subtraktion von k div n alleine zu kompensierten Digitalwerten D2' führen würde, die im Mittel etwas zu hoch sind.

Es ist zu beachten, dass die Subtraktionsoperationen in der Offset-Korrekturschaltung nach Fig. 2 durch Additionen ersetzt werden können (oder umgekehrt), falls die entsprechenden Werte mit umgekehrten Vorzeichen verwendet werden.

In der Schaltung nach Fig. 2 wird der kompensierte Digitalwert D2' zusammen mit dem (in dieser Ausführung nicht kompensierten) Digitalwert D1 einer Speicheransteuerung 8 zugeführt, wo die beiden Werte zu einer 9 Bit Adresse A kombiniert und einem Speicher 9 zugeführt werden. Der Speicher 9 enthält alle Werte der Lookup-Tabelle 3 und erzeugt den Lookup-Wert D. (Die Digitalwerte D1 und D2 können auch nur einen Teil der Adresse A bilden, wobei der andere Teil der Adresse A z.B. durch ein Steuersignal erzeugt wird, welches eine von mehreren Tabellen im Speicher 9 auswählt.)

Der Lookup-Wert D wird dem Dezimationsfilter bzw. der Integrationsstufe 4 zugeführt, die aus einem Addierer 10 und einem Register 11 besteht. Der Addierer 10 addiert den Lookup-Wert D und den Wert im Register 11. Die Summe wird mit einem Taktsignal Clk3 am Schluss jeder Messperiode im Register D abgespeichert. Nach $2^6$ Messperioden wird das so erzeugte Ausgangssignal, welches der Summe der letzten $2^6$ Lookup-Werte D entspricht, am Ausgang O an ein (nicht gezeigtes) Register weitergegeben, wo gegebenenfalls noch eine Division (bzw. eine Schiebeoperation) durchgeführt wird, um die tiefstwertigen Bits zu eliminieren. Sodann wird das Register 11 über ein Signal Res2 zurückgesetzt.

In der hier gezeigten Schaltung muss der Speicher 9 mindestens $2^9$ = 512 Werte von 12 Bit Länge enthalten. Verglichen mit der hohen erreichbaren Auflösung ist dies ein geringer Wert. Durch geeignete Schaltungstechniken kann die erforderliche Speicherkapazität jedoch, wie im anhand des folgenden Ausführungsbeispiels beschrieben, noch weiter reduziert oder bei gleicher Speicherkapazität eine noch höhere Auflösung erzielt werden.

In der Schaltung nach Fig. 1 ist der Ausgangswert O eine vorgegebene Funktion f der analogen Eingangswerte I1, I2 bzw. der Digitalwerte D1, D2:

$$O = f(D1, D2). \qquad (1)$$

D1 und D2 sind ganzzahlige Werte. Wenn wir annehmen, dass wir f(i, j) für ein gegebenen Wertepaar D1=i, D2=j kennen, so lässt sich f für die nächst höheren Werte von i+1, j und i, j+1 errechnen aus:

$$f(i+1, j) = f(i, j) + S1 + w1_{i+1,j} \qquad (2)$$

$$f(i, j+1) = f(i, j) + S2 + w2_{i,j+1}$$

Dabei S1 und S2 konstante, d.h. von i und j unabhängige Werte, die die mittlere Steigung von f in D1 und D2 angeben. S1 und S2 können z.B. aus einer linearen Regression von f erhalten werden. $w1_{ij}$ und $w2_{ij}$ sind relativ kleine Korrekturwerte, die die lokale Abweichung der Funktion f von einer linearen Interpolation mit den Steigungen S1 bzw. S2 quantifizieren:

$$w1_{i,j} = f(i, j) - f(i-1, j) - S1 \qquad (3)$$

$$w2_{i,j} = f(i, j) - f(i, j-1) - S2$$

Die der zweiten Ausführung der Erfindung zugrundeliegende Idee ist es, in der Tabelle nicht die Funktionswerte f(i,j) sondern die Korrekturwerte $w1_{ij}$ und $w2_{ij}$ abzuspeichern, wie dies im folgenden beschrieben wird.

Das Ausführungsbeispiel nach Fig. 3 besitzt keine Offsetkorrektur und Addierer 10 wurde durch eine Arithmetikeinheit 10' ersetzt. Im Gegensatz zur ersten Ausführung wird der Integrator 4 mit wesentlich höherer Taktrate betrieben und die Zugriffe auf den Speicher 9 sind häufiger. Das Taktsignal Clk3 des Integrators 4 wird im folgenden als Referenztakt und die entsprechende Taktrate als Referenztaktrate bezeichnet.

Die Taktsignale Clk1 und Clk2 für die Zähler 1b und 2b laufen mit der halben Referenztaktrate und sind gegeneinander um 180° verschoben.

Im Speicher 9 sind die Korrekturwerte $w1_{ij}$ und $w2_{ij}$ abgespeichert. Ein Steuersignal Sel, welches ebenfalls mit der halben Referenztaktrate betrieben wird, zeigt der Speicheransteuerung 8 durch seinen Wert an, ob $w1_{i,j}$ oder $w2_{i,j}$ abzurufen ist, wobei die Indizes i, j den momentanen Werten von D1 bzw. D2 entsprechen. Für das folgende Beispiel wird angenommen, dass bei Sel = 0 der Wert $w1_{i,j}$ und bei Sel = 1 der Wert $w2_{i,j}$ abgerufen wird.

Der Arithmetikeinheit 10' werden die Linearitätskonstanten S1, S2, der Ausgangswert D des Speichers 9 und das Ausgangssignal O von Register 11 zugeführt. Als Steuersignale liegen an der Arithmetikeinheit ferner die Binärwerte B1 und B2 sowie das Steuersignal Sel an. Abhängig von diesen Signalen erzeugt die Arithmetikeinheit 10' folgende Resultate:

| Sel | B1 | B2 | Resultat | Bemerkung |
|-----|----|----|----------|-----------|
| 0 | 0 | x | O | D = w1 |
| 0 | 1 | x | O+S1+D | D = w1 |
| 1 | x | 0 | O | D = w2 |
| 1 | x | 1 | O+S2+D | D = w2 |

(Hierbei bedeutet "x", dass der entsprechende Wert keinen Einfluss auf das Resultat hat.)

Das Steuersignal Sel zeigt also an, ob B1 oder B2 zu prüfen ist. Ist der zu prüfende Binärwert B1 bzw. B2 0, so gibt die Arithmetikeinheit 10' das Ausgangssignal O an den Eingang von Register 11 weiter, ist er 1, so ist das Resultat gleich O + S1 + w1 bzw. O + S2 + w2.

Die Funktion der Schaltung nach Fig. 3 ist wie folgt:

Zu Beginn einer Messperiode werden die Zähler 1b, 2b und das Register 11 auf 0 gesetzt. Sodann wird ein erster Taktimpuls an den Zähler 1b angelegt. Ist der entsprechende Binärwert B1 = 1, so wird der Zähler erhöht. Mit dem Steuersignal Sel = 0 wird dem Speicher 9 angezeigt, dass er den Wert $w_{10}$ abzurufen hat. Dieser Wert wird der Arithmetikeinheit 10' zugeführt, die gemäss obiger Tabelle den Ausgangswert $O+w_{10}+S1$ berechnet, der mit einem Taktpuls Clk3 im Register 11 abgespeichert wird

Ist hingegen B1 = 0, so ist das Ausgangssignal der Arithmetikeinheit 10' gleich O, d.h. der Wert von Register 11 bleibt unverändert auf 0.

In einem nächsten Zyklus ist Sel = 1 und es wird ein Taktimpuls an den Zähler 2b angelegt. In Speicher 9 wird $w_{01}$ abgerufen und, wenn B2=1 ist, zusammen mit S2 zu O hinzuaddiert.

Dieser Ablauf wiederholt sich bis zum Ende der Messperiode. Ist z.B. D1=i und D2=j und erhöht sich der Zähler 1b um 1, so erhöht sich O um den Wert S1 + $w_{i+1,j}$, entsprechend Gleichung (2). Somit ist O am Schluss einer Messperiode gleich f(D1, D2).

Die Zähler 1b, 2b werden für die nächste Messperiode zurückgesetzt, nicht aber das Register 11. Vielmehr werden in Register 11 die Resultate mehrerer Messperioden aufaddiert, so dass, wie in der Ausführung nach Fig. 2, die Auflösung der Ausgangswerts erhöht wird.

Am Schluss von z.B. $2^6$ Messperioden wird der Ausgangswert in einem nicht gezeigten Ausgangsregister abgespeichert (und gegebenenfalls skaliert), und das Register 11 wird zurückgesetzt.

Bei den obigen Ausführungen wird angenommen, dass das Ausgangssignal bei I1=I2=0 ebenfalls 0 sein soll. Anderenfalls kann das Register 11 zu Beginn einer Messperiode auf einen gewünschten Anfangswert ungleich 0 zurückgesetzt werden, der $2^6$ mal dem Grundoffset entspricht.

Dank der rekursiven Berechnung gemäss Gleichung (2) müssen im Speicher 9 lediglich die Abweichungen der Funktion f von einem linearen Verhalten abgespeichert werden. Diese Abweichungen sind in der Regel wesentlich kleiner als die Funktionswerte selbst, so dass sie mit kleinerer Auflösung bzw. Bitlänge abgespeichert werden können.

Es ist auch denkbar, die Konstanten S1 und S2 auf 0 zu setzen. In diesem Falle würde der Aufbau der Arithmetikeinheit 10' einfacher. Im Speicher 9 wären in diesem Falle die Differenzen aufeinander folgender Funktionswerte f abgespeichert.

Eine weitere Ausführung der Erfindung ist in Fig. 4 schematisch dargestellt. Als Erweiterung des Konzepts nach Fig. 1, 2 oder 3 wird hier die Lookup-Tabelle als Speicher 9 implementiert, der über eine Cache-Steuerung 14 angesteuert wird. Die Cache-Schaltung 14 speichert in bekannter Weise die letzten oder die am meisten zugegriffenen Speicherwerte und deren Adressen. Dadurch wird die Zahl der Zugriffe auf den Speicher reduziert. Dies vermindert dessen Stromaufnahme und sowie die von ihm erzeugten Störsignale.

Während in der vorliegenden Anmeldung bevorzugte Ausführungen der Erfindung beschrieben sind, ist klar darauf hinzuweisen, dass die Erfindung nicht auf diese Beschränkt ist und in auch anderer Weise innerhalb des Umfangs der folgenden Ansprüche ausgeführt werden kann.

**Patentansprüche**

1. A/D-Wandler mit mindestens einem ersten und einem zweiten analogen Eingang (I1, I2) für analoge Eingangswerte, wobei jeder Eingang mit je einem Wandler (1, 2) verbunden ist, um einen ersten bzw. ein zweiten Digitalwert (D1, D2) zu erzeugen, **dadurch gekennzeichnet, dass**
eine Tabellenanordnung (3) vorgesehen ist, um aus den Digitalwerten (D1, D2) zusammen einen Lookup-Wert (D) zu erzeugen, und dass
ein Dezimationsfilter (4) vorgesehen ist, um aus mehreren, aufeinander folgenden Lookup-Werten (D) durch Addition oder Mittelung einen Ausgangswert (O) zu erzeugen, so dass der Ausgangswert (O) höhere Auflösung als der Lookup-Wert (D) besitzt.

2. A/D-Wandler nach Anspruch 1, **dadurch gekennzeichnet, dass** zur Offsetkompensation für mindestens einen der Eingänge (I1, I2) eine Korrekturschaltung (6, 7) vorgesehen ist, die einen Korrekturwert zum/vom zu kompensierenden Digitalwert (D2) addiert oder subtrahiert um einen korrigierten Digitalwert (D2') zu erzeugen.

3. A/D-Wandler insbesondere nach einem der vorangehenden Ansprüche, mit mindestens einem analogen Eingang (I1, I2) für einen analogen Eingangswert, wobei der Eingang mit einem Wandler (1, 2) verbunden ist, um einen Digitalwert (D1, D2) zu erzeugen, mit einer Tabellenanordnung, welche den Digitalwert (D1, D2) nichtlinear in einem Lookup-Wert (D) transformiert und mit einem Dezimationsfilter (4), um aus mehreren, aufeinander folgenden Lookup-Werten (D) einen Ausgangswert (O) zu erzeugen, so dass der Ausgangswert (O) höhere Auflösung als der Lookup-Wert (D) besitzt,
**dadurch gekennzeichnet, dass** zur Offsetkompensation eine Korrekturschaltung (6, 7) vorgesehen ist, die einen Korrekturwert zum/vom zu kompensierenden Digitalwert (D2) addiert oder subtrahiert um einen korrigierten Digitalwert (D2') zu erzeugen, wobei
ein Offset-Ermittler (7) zur Messung des Offsets der zu kompensierenden Digitalwerte (D2) bei bekanntem Eingangswert am Eingang (I2) vorgesehen ist, wobei der Offset-Ermittler (7) ausgestaltet ist, um den Offset von n Digitalwerten (D2) aufzuaddieren und daraus ein Korrekturwort k zu erzeugen, das höhere Auflösung als die Digitalwerte (D2) aufweist, und dass die Offsetkompensation (6, 7) ausgestaltet ist, um das durch n dividierte Korrekturwort k zu/von jedem zu kompensierenden Digitalwert (D2) zu addieren bzw. subtrahieren.

4. A/D-Wandler nach Anspruch 3, **dadurch gekennzeichnet, dass** die Offsetkompensation (6, 7) ausgestaltet ist, um den Wert k div n von jedem zu kompensierenden Digitalwert (D2) zu subtrahieren und zusätzlich insgesamt den Wert k mod n von einer Gruppe von n zu kompensierenden Digitalwerten (D2) zu subtrahieren.

5. A/D-Wandler nach Anspruch 4, **dadurch gekennzeichnet, dass** die Offsetkompensation ausgestaltet ist, um den Wert 1 von insgesamt k mod n Digitalwerten (D2) der Gruppe zu subtrahieren, und insbesondere dass ein Zähler vorgesehen ist, um die k mod n Digitalwerte zu zählen, von denen der Wert 1 zu subtrahieren ist.

6. A/D-Wandler nach einem der Ansprüche 3 - 5, **dadurch gekennzeichnet, dass** $n = 2^z$ ist, wobei z eine natürliche Zahl grösser 1 ist.

7. A/D-Wandler nach einem der vorangehenden Ansprüche, **dadurch gekennzeichnet, dass** die Digitalwerte (D1, D2) proportional zum jeweiligen Eingangswert sind.

8. A/D-Wandler nach einem der vorangehenden Ansprüche, **dadurch gekennzeichnet, dass** die Wandler je einen Umsetzer (1a, 2a) und einen Filter (1b, 2b) umfassen, wobei jeder Umsetzer (1a, 2a) aus dem Eingangswert eine Folge (B1, B2) von Binärwerten erzeugt, wobei die Zahl der Binärwerte mit Wert 1 proportional zum Eingangswert ist, und der Filter (1b, 2b) zur Erzeugung des Digitalwerts die innerhalb einer Messperiode anfallenden Binärwerte des Werts 1 zählt oder mittelt.

9. A/D-Wandler nach Anspruch 8, **dadurch gekennzeichnet, dass** die Filter (1b, 2b) als Zähler ausgestaltet sind, dass die Tabellenanordnung Differenzwerte (w1, w2) abhängig von den Werten der Zähler (1b, 2b) liefert, und dass der Dezimationsfilter (4) als Integrationsstufe ausgestaltet ist, um bei jeder Erhöhung eines der Zähler (1b, 2b) den Lookup-Wert aus der Tabelle zu einem Zwischenresultat hinzuzuaddieren.

10. A/D-Wandler nach Anspruch 9, **dadurch gekennzeichnet, dass** der Dezimationsfilter (4) das Zwischenresultat nach einer Integrationsperiode als Ausgangswert (O) abgibt, wobei die Integrationsperiode mehrere Messperioden umfasst.

11. A/D-Wandler nach einem der Ansprüche 9 - 10, **dadurch gekennzeichnet, dass** die Filter (1b, 2b) als Zähler ausgestaltet sind, und dass die Integrationsstufe (4) ausgestaltet ist, um bei jeder Erhöhung eines der Zähler (1b, 2b) den Lookup-Wert (D) aus der Tabelle zum Zwischenresultat und zu einer Proportionalitätskonstanten (S1, S2) hinzuzuaddieren, wobei der Wert der Proportionalitätskonstante (S1, S2) davon abhängt, welcher der Zähler (S1, S2) erhöht wurde.

**12.** A/D-Wandler nach einem der vorangehenden Ansprüche, **dadurch gekennzeichnet, dass** die Tabellenanordnung (3) einen Speicher (9) mit Adresseingang aufweist, und dass die Digitalwerte (D1, D2), gegebenenfalls nach einer Offset-Korrektur, als Adressen oder Adressteile dem Adresseingang zugeführt werden.

**13.** A/D-Wandler nach Anspruch 12, **dadurch gekennzeichnet, dass** eine Cache-Schaltung (14) vorgesehen ist, welche einen Teil der erzeugten Adressen (A) und die dazugehörigen Lookup-Werte (D) zwischenspeichert, um die Zahl der Zugriffe auf den Speicher (9) zu reduzieren.

**14.** A/D-Wandler nach einem der vorangehenden Ansprüche, **dadurch gekennzeichnet, dass** die Wandler (1, 2) inkrementale A/D-Wandler oder $\Sigma\Delta$-Wandler sind.

**Claims**

**1.** A/D-converter with at least a first and a second analog input (I1, I2) for analog input values, wherein each input is connected to a converter (1, 2) for generating a first and a second digital value (D1, D2), respectively, **characterized in that**

a table arrangement (3) is provided for generating a lookup value (D) from the digital values (D1, D2) and that

a decimation filter (4) is provided for generating an output value (O) from several consecutive lookup values (D) by addition or averaging such that the output value (O) has a higher resolution than the lookup value (D).

**2.** A/D-converter of claim 1 **characterized in that** a correction circuit (6, 7) is provided for offset compensation for at least one of the inputs (I1, I2), which adds or subtracts a correction value to/from the digital value (D2) to be compensated for generating a corrected digital value (D2').

**3.** A/D-converter in particular of any of the preceding claims with at least one analog input (I1, I2) for an analog input value, wherein the input is connected to a converter (1, 2) for generating a digital value (D1, D2), with a table arrangement, which transforms the digital value (D1, D2) in nonlinear manner into a lookup value (D), and with a decimation filter (4) for generating an output value (O) from several consecutive lookup values (D) such that the output value (O) has higher resolution than the lookup-value (D),

**characterized in that** a correction circuit (6, 7) is provided for offset compensation, which adds or subtracts a correction value to/from the digital value (D2) for generating a corrected digital value (D2'), wherein

an offset detector (7) is provided for measuring the offset of the digital values (D2) to be compensated at a known input value at the input (I2), wherein the offset detector (7) is designed for adding up the offset of n digital values (D2) and generating a correction word k therefrom, which has higher resolution than the digital values (D2), and that the offset compensation (6, 7) is designed for adding or subtracting the correction word k divided by n to/from each digital value (D2) to be compensated.

**4.** A/D-converter of claim 3 **characterized in that** the offset compensation (6, 7) is designed for subtracting the value k div n from each digital value (D2) to be compensated and, in addition, subtracting totally the value k mod n from a group of n digital values (D2) to be compensated.

**5.** A/D-converter of claim 4 **characterized in that** the offset compensation is designed to subtract the value 1 from totally k mod n digital values (D2) of the group, and in particular that a counter is provided for counting the k mod n digital values from which the value 1 is to be subtracted.

**6.** A/D-converter of any of the claims 3 - 5 **characterized in that** $n = 2^z$, wherein z is a integer number larger than 1.

**7.** A/D-converter of any of the preceding claims **characterized in that** the digital values (D1, D2) are proportional to the corresponding input value.

**8.** A/D-converter of any of the preceding claims **characterized in that** each converter comprises a digitizer (1a, 2a) and a filter (1b, 2b), wherein each digitizer (1a, 2a) generates a series (B1, B2) of binary values, wherein the number of binary values with value 1 is proportional to the input value, and the filter (1a, 2b) counts the number of binary values of value 1 within a measuring period for generating the digital value.

**9.** A/D-converter of claim 8, **characterized in that** the filters (1b, 2b) are designed as counters, that the table arrangement supplies difference values (w1, w2) depending on the values of the counters (1b, 2b), and that the decimation filter (4) is designed as an integration stage for adding the lookup value from the table to an intermediate result at each increment of one of the counters (1b, 2b).

10. A/D-converter of claim 9, **characterized in that** the decimation filter (4) supplies the intermediate result after an integration period as an output value (O), wherein the integration period comprises several measuring periods.

11. A/D-converter of any of the claims 9 - 10, **characterized in that** the filters (1b, 2b) are designed as counters and that the integration stage (4) is designed to add the lookup value (D) from the table to the intermediate result and to a proportionality constant (S1, S2) upon each increment of one of the counters (1b, 2b), wherein the value of the proportionality constant (S1, S2) depends on which one of the counters (S1, S2) was incremented.

12. A/D-converter of one of the preceding claims, **characterized in that** the table arrangement (3) comprises a memory (9) with address input, and that the digital values (D1, D2), where applicable after an offset correction, are fed as addresses or parts of addresses to the address input.

13. A/D-converter of claim 12, **characterized in that** a cache circuit (14) is provided that caches a part of the generated addresses and the corresponding lookup values (D) for reducing the number of accesses to the memory (9).

14. A/D-converter of any of the preceding claims **characterized in that** the converters (1, 2) are incremental A/D-converters or $\Sigma\Delta$-converters.

**Revendications**

1. Convertisseur analogique-numérique avec au moins une première et une seconde entrée analogique (I1, I2) pour recevoir des valeurs analogiques d'entrée, chaque entrée étant connectée à un convertisseur pour générer une première, respectivement une seconde valeur numérique (D1, D2), **caractérisé**

en ce qu'il est prévu un dispositif tabulaire (3) pour créer à partir des valeurs numériques (D1, D2) une valeur (D) de look-up, et

en ce qu'il est prévu un filtre à décimation (4) pour former, par addition ou calcul d'une moyenne à partir de plusieurs valeurs de look-up successives (D), une valeur de sortie (O) de manière à ce que la résolution de celle-ci soit supérieure à celle de la valeur de look-up (D).

2. Convertisseur analogique-numérique selon la revendication 1, **caractérisé en ce que** pour compenser l'offset il est prévu pour au moins une des entrées (I1, I2) un circuit correcteur (6, 7) qui ajoute à la valeur digitale (D2) à compenser ou soustrait de celle-ci une valeur correctrice afin d'obtenir une valeur numérique corrigée (D2').

3. Convertisseur analogique-numérique, en particulier selon une des revendications précédentes, avec au moins une entrée analogique (I1, I2) connectée à un convertisseur (1, 2) pour générer une valeur numérique (D1, D2), et avec un dispositif tabulaire transformant de façon non-linéaire cette valeur numérique (D1, D2) en une valeur de look-up (D), ainsi qu'avec un filtre à décimation (4) pour générer à partir de plusieurs valeurs de look-up successives (D) une valeur de sortie (O) de façon à ce que la résolution de celle-ci soit supérieure à celle de la valeur de look-up (D),

**caractérisé en ce qu'**il est prévu pour la compensation de l'offset un circuit correcteur (6, 7) qui ajoute à la valeur numérique à compenser (D2) ou soustrait de celle-ci une valeur correctrice afin d'obtenir une valeur numérique corrigée (D2'),

un déterminateur d'offset (7) étant prévu pour mesurer l'offset des valeurs numériques (D2) à compenser lorsque la valeur d'entrée à l'entrée (I2) est connue, le déterminateur d'offset (7) étant agencé pour additionner les offsets de n valeurs numériques (D2) et pour calculer à partir de là un terme de correction k dont la résolution est supérieure à celle de la valeur numérique (D2), la compensation d'offset (6, 7) étant réalisée de façon à ajouter le quotient du terme de correction k divisé par n à chaque valeur numérique (D2) à compenser, respectivement pour soustraire ce quotient de ladite valeur numérique.

4. Convertisseur analogique-numérique selon la revendication 3, **caractérisé en ce que** la compensation de l'offset (6, 7) est réalisée de façon à soustraire de chaque valeur numérique à compenser (D2) la valeur k div n et de façon à soustraire en outre au total la valeur k mod n d'un groupe de n valeurs numériques (D2) à compenser.

5. Convertisseur analogique-numérique selon la revendication 4, **caractérisé en ce que** la compensation de l'offset est réalisée de façon à soustraire la valeur 1 d'un total de k mod n valeurs numériques (D2) du groupe, et en particulier **en ce qu'**il est prévu un compteur pour compter les k mod n valeurs numériques dont il faut soustraire la valeur 1.

6. Convertisseur analogique-numérique selon une des revendications 3 à 5, **caractérisé en ce que** n = $2^z$, où z est un nombre naturel plus grand que 1.

7. Convertisseur analogique-numérique selon une des revendications précédentes, **caractérisé en ce que** chacune des valeurs numériques (D1, D2) est proportionnelle à la valeur d'entrée correspondante.

**8.** Convertisseur analogique-numérique selon une des revendications précédentes, **caractérisé en ce que** les convertisseurs comportent chacun un transpondeur (1a, 2a) et un filtre (1b, 2b), chaque transpondeur (1a, 2a) générant à partir de la valeur d'entrée une suite (B1, B2) de valeurs binaires, le nombre de valeurs binaires égales à 1 étant proportionnel à la valeur d'entré, et le filtre (1b, 2b) étant agencé pour compter les valeurs binaires égales à 1 qui apparaissent pendant un intervalle de mesure ou pour déterminer la moyenne de ces valeurs binaires afin de générer la valeur numérique.

**9.** Convertisseur analogique-numérique selon la revendication 8, **caractérisé en ce que** les filtres (1b, 2b) sont des compteurs, que le dispositif tabulaire fournit des valeurs formant des différences (w1, w2) en fonction des valeurs des compteurs (1b, 2b), et que le filtre à décimation (4) est un circuit d'intégration agencé pour additionner, lors de chaque incrément d'un des compteurs (1b, 2b), la valeur de look-up extraite du tableau à un résultat intermédiaire.

**10.** Convertisseur analogique-numérique selon la revendication 9, **caractérisé en ce que** le filtre à décimation (4) délivre comme valeur de sortie (O) le résultat intermédiaire obtenu après un intervalle d'intégration, cet intervalle d'intégration comprenant plusieurs intervalles de mesure.

**11.** Convertisseur analogique-numérique selon une des revendications 9 ou 10, **caractérisé en ce que** les filtres (1b, 2b) sont des compteurs et que le circuit d'intégration (4) est agencé pour additionner, lors de chaque incrément d'un des compteurs (1b, 2b), la valeur de look-up (D) extraite du tableau au résultat intermédiaire et à une constante de proportionalité (S1, S2) dont la valeur dépend de l'identité du compteur (S1, S2) dont la valeur a été augmentée.

**12.** Convertisseur analogique-numérique selon une des revendications précédentes, **caractérisé en ce que** le dispositif tabulaire (3) comporte une mémoire (9) avec entrée d'adresses et que les valeurs numériques (D1, D2) sont délivrées comme adresses ou parties d'adresses à cette entrée d'adresses, le cas échéant après une correction d'offset.

**13.** Convertisseur analogique-numérique selon la revendication 12, **caractérisé en ce qu'**il est prévu un circuit formant cache (14) pour mémoriser provisoirement une partie des adresses générées (A) ainsi que les valeurs de look-up (D) correspondantes afin de réduire le nombre d'accès à la mémoire (9).

**14.** Convertisseur analogique-numérique selon une des revendications précédentes, **caractérisé en ce que** les convertisseurs (1, 2) sont des convertisseurs A/D à incrément ou des convertisseurs $\Sigma\Delta$.

Fig. 1

Fig. 2

**Fig. 3**

**Fig. 4**